# EUROPÄISCHE PATENTANMELDUNG

(11) **EP 1 306 681 A2**
(43) Veröffentlichungstag der Anmeldung: **02.05.2003**
(21) Anmeldenummer: 02102220.7
(22) Anmeldetag: 27.08.2002
(51) Int. Cl.: G01R 31/30

(54) **Verfahren und Anordnung zur Ermittlung des Hochfrequenzverhaltens von aktiven Schaltungselementen**

(30) Priorität: 28.08.2001 DE 10142021
(71) Anmelder: Philips Corporate Intellectual Property GmbH, 20099 Hamburg (DE); Koninklijke Philips Electronics N.V., 5621 BA Eindhoven (NL)
(72) Erfinder: Schäfer, Martin, 52088, Aachen (DE); Wichern, Andreas, 52088, Aachen (DE)
(74) Vertreter: Volmer, Georg, Dipl.-Ing.

(57) **Zusammenfassung**

Bei einem Verfahren und einer Anordnung zur Ermittlung des Hochfrequenzverhaltens von aktiven Schaltungselementen in auf einer Substratscheibe befindlichen Schaltungen, wobei stellvertretend für die aktiven Schaltungselemente in den Schaltungen aktive Schaltungselemente in ebenfalls auf der Substratscheibe befindlichen Prozeßkontrollmodulen benutzt werden, wird die Schwingfrequenz von in den Prozeßkontrollmodulen enthaltenen aus aktiven Schaltungselementen aufgebauten Ringoszillatoren gemessen und ausgewertet.

## Beschreibung

Die Erfindung betrifft ein Verfahren und eine Anordnung zur Ermittlung des Hochfrequenzverhaltens von aktiven Schaltungselementen in auf einer Substratscheibe befindlichen Schaltungen, wobei stellvertretend für die aktiven Schaltungselemente in den Schaltungen aktive Schaltungselemente in ebenfalls auf der Substratscheibe befindlichen Prozeßkontrollmodulen benutzt werden.

Um Eigenschaften der Einzelkomponenten von integrierten Schaltungen im Produktionsprozeß möglichst frühzeitig erkennen zu können, sind auf den Substratscheiben (Wafern) neben den zu produzierenden Schaltungen sogenannte Prozeßkontrollmodule vorgesehen, die somit die gleichen Prozesse durchlaufen haben wie die Schaltungen und für relativ einfache Messungen ausgelegt sind. In den Prozeßkontrollmodulen befinden sich im wesentlichen die gleichen Einzelkomponenten, aus denen die Schaltungen aufgebaut sind. Die Messungen können am Ende der Herstellung der Schaltung durchgeführt werden, um den Scheibenherstellungsprozeß zu kontrollieren und gegebenenfalls für nachfolgende Chargen zu optimieren. Ein solches Verfahren ist beispielsweise durch US 4,079,505 bekanntgeworden. Ein weiteres Verfahren unter Verwendung von Prozeßkontrollmodulen ist in US 4,364,010 beschrieben, das sich wie das erstgenannte auf eine DC-Charakterisierung von Bipolar-Transistoren bezieht.

Entsprechend dem Bedarf der fortschreitenden Kommunikationstechnik werden Halbleiter-Schaltungen für sehr hohe Frequenzen benötigt, wobei die Transitfrequenz für Biopolartransistoren beispielsweise im Bereich von 10 GHz bis 50 GHz liegt. Die Transitfrequenz ist eine häufig zur Beschreibung von Hochfrequenzeigenschaften verwendete Größe und ist diejenige Frequenz, bei welcher der Biopolartransistor nur noch eine Verstärkung von 1 hat. Die eigentliche Betriebsfrequenz von Biopolartransistoren liegt maximal bei 1/3 der Transitfrequenz. Auch MOS-Transistoren können nur bis zu bestimmten Frequenzen verwendet werden. Bei höheren Frequenzen verlieren sie die für die Schaltung nötigen Eigenschaften.

Aufgabe der vorliegenden Erfindung ist es, ein Verfahren und eine Anordnung anzugeben, mit denen das Hochfrequenzverhalten von aktiven Schaltungselementen direkt am Ende des Fertigungsprozesses auf der Substratscheibe ermittelt werden kann.

Diese Aufgabe wird bei dem erfindungsgemäßen Verfahren dadurch gelöst, dass die Schwingfrequenz von in den Prozeßkontrollmodulen enthaltenen aus Transistoren aufgebauten Ringoszillatoren gemessen und ausgewertet wird.

Durch die Verwendung eines Ringoszillators ist diejenige Frequenz, die unter Verwendung entsprechender Meßapparaturen und Kontaktvorrichtungen (Leitungen, Kontaktnadeln) erfaßt werden muß, relativ niedrig. Sie beträgt beispielsweise etwa 600 MHz bei der Verwendung eines Ringoszillators mit 10 Stufen, wenn die Transitfrequenz der Transistoren etwa 10 GHz entspricht.

Das erfindungsgemäße Verfahren eignet sich im wesentlichen dafür, zum Abschluß des Herstellungsprozesses der aktiven Schaltungselemente auf der Substratscheibe durchgeführt zu werden. Dabei können Ausfälle rechtzeitig vor der Durchführung weiterer kostenintensiver Fertigungsschritte, wie beispielsweise Vereinzeln und Konfektionieren der Schaltungen, erkannt werden. Außerdem können Daten zur Einstellung der Parameter für die folgenden Chargen gewonnen werden. Die Erfindung ist anwendbar bei verschiedenen aktiven Schaltungselementen, wie Bipolar-Transistoren, Feldeffekttransistoren und anderen auf Wafern herstellbaren, verstärkenden Elementen.

Die gemessene Schwingfrequenz kann an sich bereits einer Schlecht/Gut-Beurteilung zugrunde gelegt werden, wenn entsprechende Vergleichswerte bekannt sind. In vielen Fällen ist man jedoch an der Ermittlung der Transitfrequenzen der Transistoren interessiert. Eine Weiterbildung des erfindungsgemäßen Verfahrens besteht deshalb darin, dass zur Gewinnung von Werten für die Transitfrequenz der Transistoren an mindestens einer Substratscheibe die Schwingfrequenz und mit einem Meßverfahren außerhalb der Fertigung die Transitfrequenz derselben Transistoren gemessen wird, dass die gemessenen Werte zu einer Eichtabelle zusammengestellt werden und dass bei den laufenden Messungen der Schwingfrequenzen während der Fertigung anhand der Eichtabelle aus den Schwingfrequenzen die Transitfrequenzen bestimmt werden.

Mit einer anderen Weiterbildung des Verfahrens können weitere Erkenntnisse über die Qualität der Transistoren dadurch gewonnen werden, dass die Messungen der Schwingfrequenzen bei mehreren Kollektorströmen erfolgt.

Sollte trotz der Verwendung des Ringoszillators die zu messende Frequenz für die praktischen Erfordernisse noch zu hoch sein, kann gemäß einer anderen Weiterbildung vorgesehen sein, dass die Schwingfrequenz innerhalb des jeweiligen Prozeßkontrollmoduls geteilt wird und dass ein Signal mit der geteilten Frequenz dem jeweiligen Prozeßkontrollmodul entnommen und einem Frequenzmesser zugeleitet wird.

Eine erfindungsgemäße Anordnung besteht darin, dass in den Prozeßkontrollmodulen aus Transistoren aufgebaute Ringoszillatoren enthalten sind, deren Ausgangssignale den Prozeßkontrollmodulen entnehmbar und einer Auswertungseinrichtung zuführbar sind. Die Auswertungseinrichtung enthält im wesentlichen einen Frequenzmesser, einen Mikrocomputer und zugehörige Speicher zum Abarbeiten von Meßprogrammen und Ablegen der Meßdaten.

Die erfindungsgemäße Anordnung kann derart weitergebildet sein, dass zur Gewinnung von Werten für die Transitfrequenz der Transistoren die Auswertungseinrichtung derart ausgebildet ist, dass sie die Frequenz der Ausgangssignale (Schwingfrequenz) mißt und anhand einer Eichtabelle aus den Schwingfrequenzen die Transitfrequenzen bestimmt, wobei die Eichtabelle dadurch erstellt worden ist, dass an mindestens einer Substratscheibe die Schwingfrequenz und mit einem Meßverfahren außerhalb der Fertigung die Transitfrequenz von Transistoren in denselben Prozeßkontrollmodulen gemessen werden.

Eine andere Weiterbildung der erfindungsgemäßen Anordnung sieht vor, dass in den Prozeßkontrollmodulen Frequenzteiler vorgesehen sind, die an die Ringoszillatoren angeschlossen sind, und dass ein Signal mit der geteilten Frequenz von dem jeweiligen Frequenzteiler der Auswertungseinrichtung zuführbar ist.

Eine besonders günstige Realisierung des Ringoszillators ergibt sich bei einer vorteilhaften Ausführungsform dadurch, dass der Ringoszillator in ECL-Technik aufgebaut ist.

Ausführungsbeispiele der Erfindung sind in der Zeichnung anhand mehrerer Figuren dargestellt und in der nachfolgenden Beschreibung näher erläutert. Es zeigt:
Fig. 1 eine schematische Darstellung eines ersten Ausführungsbeispiels,
Fig. 2 eine schematische Darstellung eines zweiten Ausführungsbeispiels,
Fig. 3 ein Schaltbild eines Ringoszillators und
Fig. 4 ein Schaltbild eines Frequenzteilers.

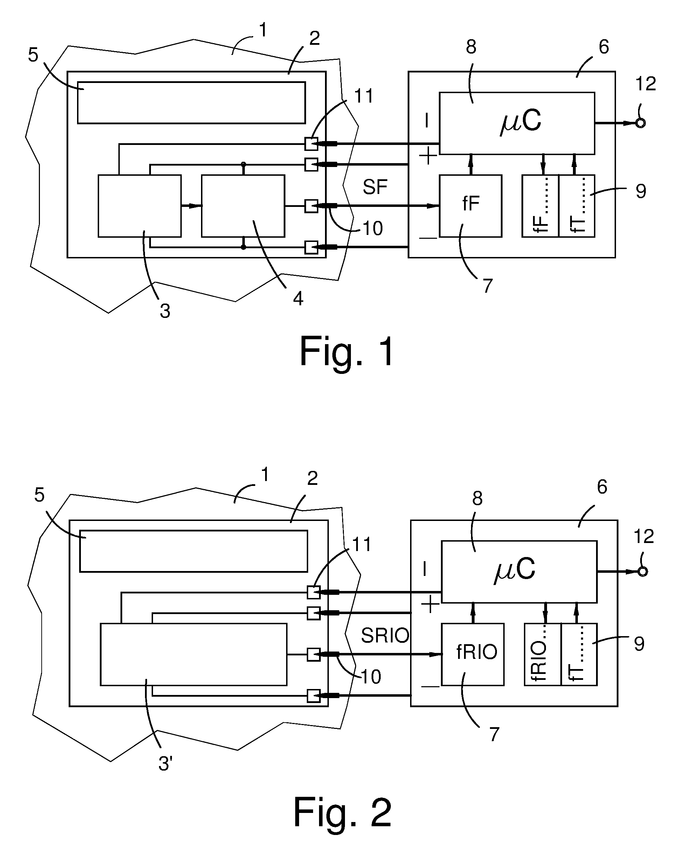

Fig. 1 zeigt einen Ausschnitt aus einer Substratscheibe 1 mit einem Prozeßkontrollmodul 2. Dieses enthält einen Ringoszillator 3, einen Frequenzteiler 4 und weitere Testschaltungen 5, die im Zusammenhang mit der vorliegenden Erfindung nicht erläutert zu werden brauchen und deshalb im einzelnen nicht dargestellt sind. Ein Testgerät 6 umfaßt im wesentlichen einen Frequenzmesser 7, einen Mikrocomputer 8 und einen Speicher 9. Weitere Schaltungen, beispielsweise Stromversorgungsschaltungen, sind der Übersichtlichkeit halber nicht dargestellt.

Das Testgerät 6 umfaßt ferner Meßkabel, deren spitzenförmige Kontakte 10 zum Messen der Prozeßkontrollmodule auf Kontaktflächen 11 aufgesetzt werden. Dabei wird dem Ringoszillator 3 und dem Frequenzteiler 4 Betriebsspannung zugeführt, die durch die Zeichen + und - symbolisiert ist. Ferner erhält der Ringoszillator 3 eine Größe I zur Steuerung des Kollektorstroms. Einem Eingang 7 des Frequenzmessers wird das Ausgangssignal SF mit der Frequenz fF zugeführt. Der Frequenzmesser 7 leitet den jeweiligen Meßwert an den Mikrocomputer 8 weiter. Dieser wird dort gespeichert, worauf der nächste Stromwert über die Größe I eingestellt wird. Nachdem die Frequenzen fF für alle in Frage kommenden Stromwerte gemessen sind, wird im Mikrocomputer 8 das Maximum festgestellt und die dazugehörige Transitfrequenz fT der im Speicher 9 abgelegten Tabelle entnommen und einem Ausgang 12 zugeführt.

Bei dem Ausführungsbeispiel nach Fig. 2 wird anstelle des Frequenzteilers ein Ringoszillator 3' mit mehr Stufen zur Erlangung einer für die praktische Messung geeigneten Frequenz verwendet. Somit wird das Ausgangssignal SRIO des Ringoszillators mit der Frequenz fRIO gemessen und zum Auslesen aus der Tabelle verwendet.

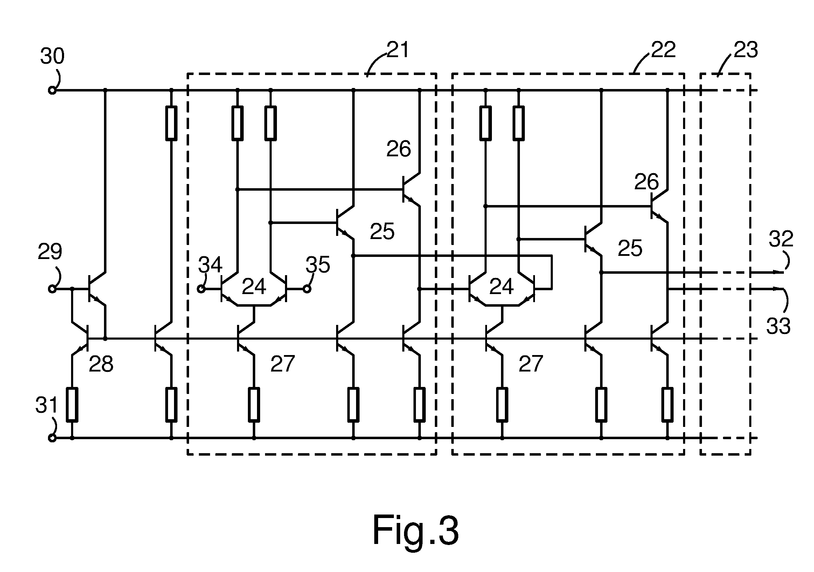

Fig. 3 zeigt als Beispiel einen Ringoszillator, wie er in integrierter Schaltungstechnik ausführbar ist. Auf die Schwingfrequenz hat außer der Zahl der Stufen des Ringoszillators fast ausschließlich die Signallaufzeit der Transistoren Einfluß. Es besteht daher eine gute Korrelation zwischen der Schwingfrequenz und der interessierenden Transitfrequenz. Die Schaltung nach Fig. 3 stellt lediglich eine von vielen möglichen Schaltungsvarianten dar, die dem Fachmann geläufig sind, um Ringoszillatoren aufzubauen.

Von den für den Ringoszillator benötigten beispielsweise zehn Stufen sind lediglich zwei Stufen 21, 22 ausführlich dargestellt, während weitere Stufen bei 23 lediglich angedeutet sind. Jede der Stufen besteht aus einem Differenzverstärker 24 und Emitterfolgern 25, 26. Sowohl die Differenzverstärker 24 als auch die Emitterfolger 25, 26 werden über Konstantstromquellen 27 betrieben. Zur Einstellung des Stroms und damit auch des Kollektorstroms der Differenzverstärker 24 dient eine Stromspiegelschaltung 28, der bei 29 über die entsprechende Kontaktfläche (Fig. 1 und Fig. 2) der vom Testgerät vorgegebene Strom I zugeführt wird. Weitere Anschlüsse 30, 31 dienen zur Zuführung der Betriebsspannung.

Die Ausgänge 32, 33 der letzten Stufe (in 23) sind mit den Eingängen 34, 35 der ersten Stufe 21 verbunden. Einem oder beiden dieser Ausgänge kann das Ausgangssignal des Ringoszillators entnommen und direkt (Fig. 2) oder über einen Frequenzteiler (Fig. 1) dem Testgerät zugeführt werden.

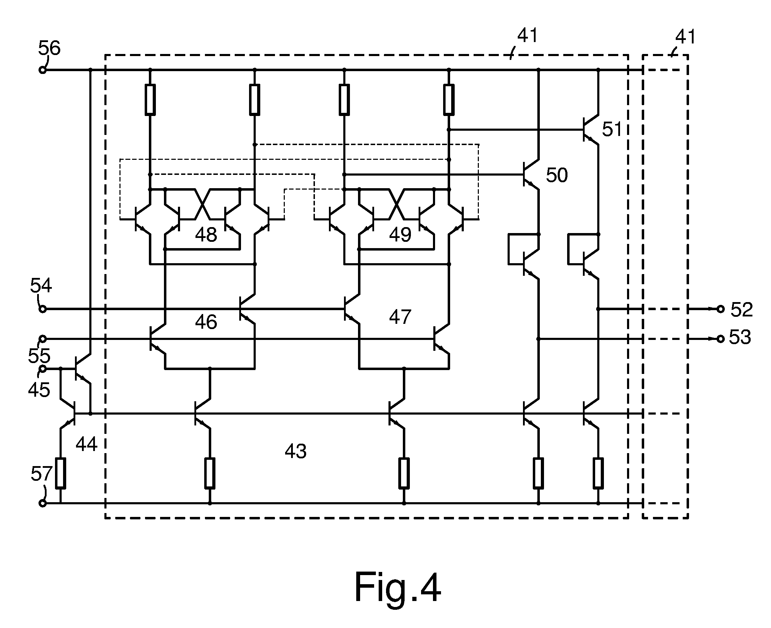

Fig. 4 zeigt ein Ausführungsbeispiel eines Frequenzteilers, wobei lediglich eine Teilerstufe 41 ausführlich dargestellt ist, während weitere Teilerstufen 42 lediglich angedeutet sind. Auch bei dieser Schaltung sind Konstantstromquellen 43 vorgesehen, wobei der Strom über eine Stromspiegelschaltung 44 von dem Testgerät über eine entsprechende Kontaktfläche bei 45 zugeführt wird. Jede der Teilerstufen besteht aus zwei parallel angesteuerten Differenzverstärkern 46, 47, in deren Kollektorkreisen bistabile Multivibratoren 48, 49 vorgesehen sind, deren Ausgänge über Emitterfolger 50, 51 mit der folgenden Stufe bzw. im Falle der letzten Teilerstufe mit Ausgängen 52, 53 verbunden sind. Das Ausgangssignal des Ringoszillators wird Eingängen 54, 55 zugeführt, während den Ausgängen 52, 53 das Ausgangssignal SF des Frequenzteilers entnehmbar ist. Betriebsspannung wird den Schaltungspunkten 56, 57 zugeführt.

## Patentansprüche

1. Verfahren zur Ermittlung des Hochfrequenzverhaltens von aktiven Schaltungselementen in auf einer Substratscheibe befindlichen Schaltungen, wobei stellvertretend für die aktiven Schaltungselemente in den Schaltungen aktive Schaltungselemente in ebenfalls auf der Substratscheibe befindlichen Prozeßkontrollmodulen benutzt werden,
**dadurch gekennzeichnet,**
**dass** die Schwingfrequenz von in den Prozeßkontrollmodulen enthaltenen aus aktiven Schaltungselementen aufgebauten Ringoszillatoren gemessen und ausgewertet wird.

2. Verfahren nach Anspruch 1,
**dadurch gekennzeichnet,**
**dass** zur Gewinnung von Werten für die Transitfrequenz der Transistoren an mindestens einer Substratscheibe die Schwingfrequenz und mit einem Meßverfahren außerhalb der Fertigung die Transitfrequenz derselben Transistoren gemessen wird, dass die gemessenen Werte zu einer Eichtabelle zusammengestellt werden und dass bei den laufenden Messungen der Schwingfrequenzen während der Fertigung anhand der Eichtabelle aus den Schwingfrequenzen die Transitfrequenzen bestimmt werden.

3. Verfahren nach einem der vorhergehenden Ansprüche,
**dadurch gekennzeichnet,**
**dass** die Messungen der Schwingfrequenzen bei mehreren Kollektorströmen erfolgt.

4. Verfahren nach einem der vorhergehenden Ansprüche,
**dadurch gekennzeichnet,**
**dass** die Schwingfrequenz innerhalb des jeweiligen Prozeßkontrollmoduls geteilt wird und dass ein Signal mit der geteilten Frequenz dem jeweiligen Prozeßkontrollmodul entnommen und einem Frequenzmesser zugeleitet wird.

5. Anordnung zur Ermittlung des Hochfrequenzverhaltens von Transistoren in auf einer Substratscheibe (1) befindlichen Schaltungen, wobei stellvertretend für die Transistoren in den Schaltungen Transistoren in ebenfalls auf der Substratscheibe (1) befindlichen Prozeßkontrollmodulen (2) benutzt werden,
**dadurch gekennzeichnet,**
**dass** in den Prozeßkontrollmodulen (2) aus Transistoren aufgebaute Ringoszillatoren (3, 3') enthalten sind, deren Ausgangssignale den Prozeßkontrollmodulen (2) entnehmbar und einer Auswertungseinrichtung (6) zuführbar sind.

6. Anordnung nach Anspruch 5,
**dadurch gekennzeichnet,**
**dass** zur Gewinnung von Werten für die Transitfrequenz der Transistoren die Auswertungseinrichtung (6) derart ausgebildet ist, dass sie die Frequenz der Ausgangssignale (Schwingfrequenz) mißt und anhand einer Eichtabelle (9) aus den Schwingfrequenzen die Transitfrequenzen bestimmt, wobei die Eichtabelle (9) dadurch erstellt worden ist, dass an mindestens einer Substratscheibe (1) die Schwingfrequenz und mit einem Meßverfahren außerhalb der Fertigung die Transitfrequenz von Transistoren in denselben Prozeßkontrollmodulen (2) gemessen werden.

7. Anordnung nach einem der Ansprüche 5 bis 6,
**dadurch gekennzeichnet,**
**dass** in den Prozeßkontrollmodulen (2) Frequenzteiler (4) vorgesehen sind, die an die Ringoszillatoren (3) angeschlossen sind, und dass ein Signal mit der geteilten Frequenz von dem jeweiligen Frequenzteiler (4) der Auswertungseinrichtung (6) zuführbar ist.

8. Anordnung nach einem der Ansprüche 5 bis 7,
**dadurch gekennzeichnet,**
**dass** der Ringoszillator (3, 3') in ECL-Technik aufgebaut ist.
